(19) Europäisches Patentamt
European Patent Office
Office européen des brevets

(11) **EP 2 391 870 B1**

(12) **EUROPÄISCHE PATENTSCHRIFT**

(45) Veröffentlichungstag und Bekanntmachung des Hinweises auf die Patenterteilung:
**22.01.2014 Patentblatt 2014/04**

(21) Anmeldenummer: **10702436.6**

(22) Anmeldetag: **29.01.2010**

(51) Int Cl.:
*G01D 5/26* (2006.01)     *G02B 6/32* (2006.01)
*H01S 5/02* (2006.01)

(86) Internationale Anmeldenummer:
**PCT/EP2010/000547**

(87) Internationale Veröffentlichungsnummer:
**WO 2010/086178 (05.08.2010 Gazette 2010/31)**

(54) **FASEROPTISCHE MESSVORRICHTUNG**

FIBER OPTIC MEASURING APPARATUS

DISPOSITIF DE MESURE À FIBRE OPTIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **02.02.2009 DE 102009007142**

(43) Veröffentlichungstag der Anmeldung:
**07.12.2011 Patentblatt 2011/49**

(73) Patentinhaber: **Draka Cable Wuppertal GmbH**
**42369 Wuppertal (DE)**

(72) Erfinder:
• **OSENBERG, Reinhard**
**42279 Wuppertal (DE)**
• **EMDE, Nico**
**58300 Wetter (DE)**
• **FUNKEN, Peter**
**50226 Frechen (DE)**

(74) Vertreter: **Richter Werdermann Gerbaulet Hofmann**
**Patentanwälte**
**Neuer Wall 10**
**20354 Hamburg (DE)**

(56) Entgegenhaltungen:
EP-A1- 1 713 151     EP-A2- 0 203 249
EP-A2- 0 930 679     EP-A2- 1 672 755
WO-A1-00/68657       WO-A1-99/32862
WO-A1-2008/044839    WO-A2-2006/105249
WO-A2-2007/103898    WO-A2-2008/062392
GB-A- 2 347 520      GB-A- 2 430 761
US-A- 5 035 511      US-A- 5 062 686
US-A1- 2006 268 241  US-B1- 6 299 104
US-B1- 6 839 366

• ARAUJO F M ET AL: "SURVEILLANCE OF FIBER OPTIC CABLES AND ELECTRIC POWER CABLES USING FIBER BRAGG GRATING SENSORS", PROCEEDINGS OF SPIE - INTERNATIONAL SOCIETY FOR OPTICAL ENGINEERING, S P I E - INTERNATIONAL SOCIETY FOR OPTICAL ENGINEERING, US, vol. 3541, 1 November 1998 (1998-11-01), pages 278-289, XP002931504, ISSN: 0277-786X, DOI: 10.1117/12.339103

• KALINOWSKI H J ET AL: "MULTIPLEXED FIBER OPTICS BRAGG GRATING SENSORS FOR STRAIN AND TEMPERATURE MEASUREMENTS IN POWER SYSTEMS", PROCEEDINGS OF SPIE - INTERNATIONAL SOCIETY FOR OPTICAL ENGINEERING, S P I E - INTERNATIONAL SOCIETY FOR OPTICAL ENGINEERING, US, vol. 3666, 1 January 1999 (1999-01-01), pages 544-553, XP002931503, ISSN: 0277-786X, DOI: 10.1117/12.347974

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Technisches Gebiet

Die Erfindung betrifft eine faseroptische Messvorrichtung mit einer Anzahl von Sensoren, welche in ein elektrisches Energiekabel integriert sind, um eine mechanische Belastung, eine Temperatur und/oder korrosive Gase zu erfassen, die auf das elektrische Energiekabel einwirken,
wobei ausgehend von einer Strahlquelle zumindest eine Lichtleitfaser vorhanden ist, an oder in welche die Sensoren vorhanden sind und die Sensoren mit Licht der Strahlquelle gespeist sind, wobei ein erster Sensor zur Erkennung der mechanischen Verformung und ein zweiter Sensor zur Erkennung der Temperatur an einer Lichtleitfaser vorhanden sind, sowie ein dritter Sensor zur Erkennung einer Biegung vorhanden ist, eine Strahlquelle und ein Verfahren hierfür.

Stand der Technik

Beim Betreiben beispielsweise von Offshore-Windkraftanlagen werden bei diesen Belastungszustände erreicht, welche durchaus auch negative Auswirkungen auf die Windkraftanlagen selbst haben, die bis zum Ausfall der Anlage oder zur Zerstörung von Bauteilen der Windkraftanlage führen können.

Für das effiziente Betreiben von Offshore-Windkraftanlagen ist es daher wichtig eine geeignete Sensorik zur permanenten Langzeiterfassung der Belastungszustände verschiedenster Anlagenbauteile vorzusehen, um die  Verfügbarkeit der Anlagen zu optimieren bzw. den Anteil der Instandhaltung zu minimieren.

Während die Belastungszustände der Rotorblätter und der Turbinengetriebe bereits in der Vergangenheit sensorisch erfasst wurden, liegen über die Belastungszustände der Nieder- und Mittelspannungskabel praktisch keine Informationen vor.

Insbesondere für Betreiber von Windkraftanlagen ist es daher grundsätzlich wünschenswert gegebenenfalls auch online und insitu Informationen über verschiedene Kabelparameter, wie beispielsweise mechanische Belastungen, Temperaturen, Korrosion usw., zu erhalten um gegebenenfalls Ersatz oder  Reparaturen mit regelmäßigen Serviceintervallen zu verbinden. Diese Informationen müssten vorteilhaft auch über ein Sensornetzwerk verfügbar sein und in einer zentralen Datenzentrale verwaltet werden können.

Ähnliches gilt für Kühlcontainer. Auch hier ist es oft problematisch eine mechanische Belastung der Kabeizuführungen, beispielsweise hervorgerufen durch Quetschungen, kontinuierlich und ortsaufgelöst zu erfassen. Lokale mechanische Belastungen können zu einem Stromausfall führen, was im Extremfall zu einer vollständigen Vernichtung der Containerladung führen kann.

Die WO 99/32862 A1 beschreibt bereits eine Vorrichtung zum Messen von Biegelasten; die einen ersten Sensor für das Messen einer Biegelast umfasst, wobei der erste Sensor ein erstes Element, das einer Biegung ausgesetzt werden kann; und eine Lichtleitfaser aufweist, die in Bezug auf das erste Element an einem ersten und zweiten Verankerungspunkt so angeordnet ist, dass die Faser vorgespannt ist, wobei die Faser ein erstes Bragg-Gitter umfasst, das in der vorgespannten Faser angeordnet ist und wobei das erste Element so angeordnet ist, dass sich bei Biegung des ersten Elements die Spannung in der Faser verringert. Weiterhin weist die Vorrichtung einen zweiten Sensor zur Erkennung der Temperatur an einer Lichtleitfaser und einen dritten Sensor zur Erkennung einer Biegung auf. Weiterhin wird eine faseroptische Messvorrichtung mit einer Anzahl von Sensoren beschrieben, welche in ein elektrisches Energiekabel integriert sind, um eine mechanische Belastung, eine Temperatur und/oder korrosive Gase zu erfassen, die auf das elektrische Energiekabel einwirken, wobei ausgehend von einer Strahlquelle zumindest eine Lichtleitfaser vorhanden ist, an oder in welche die Sensoren mit Licht der Strahlquelle gespeist sind.

Darstellung der Erfindung: Aufgabe, Lösung, Vorteile

Es ist die Aufgabe der Erfindung, eine faseroptische Messvorrichtung, eine Strahlquelle und ein Verfahren hierfür, wie insbesondere ein Sensorsystem insbesondere für Energiekabel beispielsweise für die Anwendungsfelder von Kühlcontainern und Offshore-Windkraftanlagen zu schaffen, welches es ermöglicht, den Belastungszustand der eingesetzten Energiekabel insbesondere in den Containern bzw. Windkraftanlagen für verschiedene Parameter insbesondere diskret oder kontinuierlich zu erfassen und so mögliche technische Probleme und/oder sich andeutende Ausfälle rechtzeitig zu erkennen bzw. vorherzusagen. Diese Ergebnisse sind prinzipiell übertragbar auf nahezu sämtliche Einsatzbereiche von Energiekabeln.

Dies wird bezüglich der Messvorrichtung erreicht mit den Merkmalen von Anspruch 1, wonach eine faseroptische Messvorrichtung geschaffen wird mit einer Anzahl von Sensoren, welche in Kabel integriert sind, und eine mechanische Belastung, eine Temperatur und/oder korrosive Gase erfassen, wobei die Sensoren mit Licht einer Quelle gespeist werden und die Sensoren ein faseroptisches Sensornetzwerk bilden.

Vorteilhaft ist es, wenn die Sensoren miteinander gekoppelt sind, derart, dass die Ergebnisse der Sensoren mittels einer zentralen Auswerteeinheit ausgewertet werden und/oder die Sensorelemente mit nur einer einzigen Lichtstrahlquelle betrieben werden.

Dabei ist vorgesehen, dass ausgehend von der Lichtquelle ein Strahlteiler vorgesehen ist und zumindest zwei Lichtleitfasern vorgesehen sind, an oder in welchen die Sensoren vorhanden sind.

Weiterhin ist vorgesehen, dass der Sensor zur Erkennung der mechanischen Verformung und der Sensor zur Erkennung der Temperatur an einer Lichtleitfaser vorgesehen sind.

Auch ist es sinnvoll, wenn der Sensor zur Erkennung der Biegung an der gleichen oder an einer anderen Lichtleitfaser vorgesehen ist.

Bei einem weiteren Ausführungsbeispiel ist es zweckmäßig, wenn die Einbringen von periodischen Brechungsindexstrukturen in Faser oder Lichtwellenleiter durch lokale Fokussierung ultrakurzer Lichtimpulse in den Kern der Faser, so dass je nach Periodenabstand einzelne Frequenzen einer Weißlichtquelle oder eines Breitbandemitters reflektiert werden.

Auch ist es vorteilhaft, wenn aus einer Verschiebung der rückreflektierten Frequenzanteile auf die mechanische Belastung des Kabels bzw. der Faser, beispielsweise durch Biegung oder Verdrillung geschlossen wird.

Darüber hinaus ist es vorteilhaft, wenn eine zeitaufgelöste Messung von Lichtrückstreusignalen erfolgt, nachdem ein intensiver Kurzpulslaserstrahl in ein unbehandeltes Lichtleitkabel eingekoppelt wurde.

Auch ist es zweckmäßig, wenn die zeitaufgelöste Lichtrückstreumessung für zwei unterschiedlich gestreute Lichtkomponenten die Möglichkeit der lokalen Temperaturmessung und/oder der lokalen Erfassung mechanischer Belastungen des Energiekabels ermöglicht.

Bei einem weiteren Ausführungsbeispiel ist es vorteilhaft, wenn die zwei unterschiedlich gestreute Lichtkomponenten der Stokes- und der Anti-Stokes-Anteil sind.

Vorteilhaft ist, wenn die Lichtstrahlquelle ein passiv gütegeschalteter Mikrochiplaser mit nachfolgender Weißlichterzeugung ist.

Weiterhin ist es zweckmäßig, wenn die Weißlichterzeugung durch ein nachgeschaltetes nichtlineares optisches Bauelement, vorzugsweise eine photonische Faser, erfolgt.

Auch ist es vorteilhaft, wenn aus dem Weißlichtspektrum mittels optischer Filter Frequenzbereiche herausgefiltert werden, mit welchen die einzelnen Sensorelemente angesteuert werden.

Weiterhin ist es vorteilhaft, wenn die Vernetzung der einzelnen Sensoren oder Sensorelemente durch Multiplexing erfolgt und die Abfrage der Messsignale sequentiell erfolgt.

Vorteilhaft ist weiterhin, wenn die Messvorrichtung derart ausgebildet ist, dass eine von einer Strahlquelle erzeugte elektromagnetische Strahlung in ein Lichtleitkabel einkoppelbar ist, insbesondere zur simultanen Messung von ortsaufgelösten Temperaturen und mechanischen Belastungen, wobei das Lichtleitkabel mit Faser Bragg Gittern (FBG) versehen ist.

Auch ist es vorteilhaft, wenn die Periode der FBGs so gewählt ist, dass kein FBG mit der ausgewählten Laserwellenlänge korrespondiert, so dass sich die Strahlung mit der ausgewählten Laserwellenlänge ungestört in dem Lichtwellenleiter ausbreiten kann und vorteilhaft zur ortsaufgelösten Temperatur- bzw. Quetschmessung verwendet werden kann.

Weiterhin ist es zweckmäßig, wenn die FBGs mit ultrakurzen Lichtpulsen, wie beispielsweise Femtosekunden-Lichtpulsen, in Lichtleitkabel hineingeschrieben werden.

Auch ist es vorteilhaft, wenn mittels eines Faserkopplers (218) die rücklaufenden Signalanteile der Sensoren voneinander getrennt werden.

Die Aufgabe hinsichtlich der Strahlquelle wird erreicht durch eine Strahlquelle insbesondere für eine faseroptische Messvorrichtung, insbesondere nach einem der vorhergehenden Ansprüche, zur Erzeugung von Kontinuumstrahlung und Kurzpulsemission bei einer definierten Laserwellenlänge, wobei ein Filter, wie ein Interferenzfilter die Kontinuumsemmission in einem definierten Spektralbereich um die definierte Laserwellenlänge herum unterdrückt.

Dabei ist es zweckmäßig, wenn der Interferenzfilter ein sogenannter Notch-Filter oder Sperrfilter oder Kerbfilter ist.

Dabei ist es auch zweckmäßig, wenn die Strahlquelle zur Einkopplung der erzeugten elektromagnetischen Strahlung in ein Lichtleitkabel zur simultanen Messung von ortsaufgelösten Temperaturen und mechanischen Belastungen dient, wobei das Lichtleitkabel Teil einer Messvorrichtung ist, welche mit FBGs versehen ist.

Die Aufgabe zum Verfahren wird erreicht durch ein Verfahren zum Betreiben einer oben beschriebenen faseroptischen Messvorrichtung.

Vorteilhaft ist dabei die Erfassung der folgenden Prozessgrößen, wie die ortsaufgelösten Temperaturverläufe und die mechanischen Druckbelastungen in den Kabeln. Dies kann vorteilhaft durch eine zeitaufgelöste Messung von Laserrückstreusignalen erreicht werden. Die mechanische Belastung von Kabeln, wie die Dehnung und/oder die Verdrillung kann ermittelt werden durch den Einsatz von Faser-Bragg-Sensoren und die an den Transformatoren durch Corona-Entladung entstehende Ozon-Konzentration kann mittels eines diesbezüglichen Sensors kontinuierlich erfasst werden.

Sämtliche dieser Messgrößen werden vorteilhaft durch faseroptische Einzelsensoren erfasst, die dann in einem faseroptischen Sensornetzwerk miteinander verbunden werden. Auch können einzelne Messgrößen gemeinsam von einem Sensor erfasst werden, wenn dieser entsprechend ausgebildet ist. Vorteilhaft ist es dabei, wenn die Daten der Sensoren an eine zentrale Verarbeitungseinheit weitergeleitet werden und anschließend dort vorteilhaft zentral ausgewertet und verarbeitet werden.

Um hierbei zu einer möglichst kostengünstigen und somit wirtschaftlichen Lösung zu gelangen, wird die benötigte opto-elektronische "Hardware" bzw. der benötigte opto-elektronische Sensor zentral installiert, und die einzelnen Messstellen oder -stationen, wie beispielsweise Windkraftanlagen oder Kühlcontainer werden dann über das Fasernetzwerk sequentiell abgefragt.

Eine vorteilhafte Ausgestaltung betrifft dabei die Bereitstellung des Fasernetzwerkes zur Datenerfassung und/ oder Informationsübertragung sowie das parallele oder sequentielle Abfragen der einzelnen Messstellen. Voraussetzung hierfür wiederum ist die Bereitstellung einer einzigen, geeigneten optischen Strahlquelle.

Kurze Beschreibung der Zeichnungen

Nachstehend wird die Erfindung auf der Grundlage eines Ausführungsbeispiels anhand der Zeichnungen näher erläutert. Es zeigen:

Fig. 1   eine schematische Darstellung einer faseroptischen Messvorrichtung,

Fig. 2   eine schematische Darstellung einer faseroptischen Messvorrichtung,

Fig. 3   ein Diagramm,

Fig. 4   eine schematische Darstellung einer faseroptischen Messvorrichtung,

Fig. 5a   eine schematische Darstellung einer faseroptischen Messvorrichtung,

Fig. 5b   ein Diagramm, und

Fig. 6   ein Diagramm.

Bevorzugte Ausführung der Erfindung

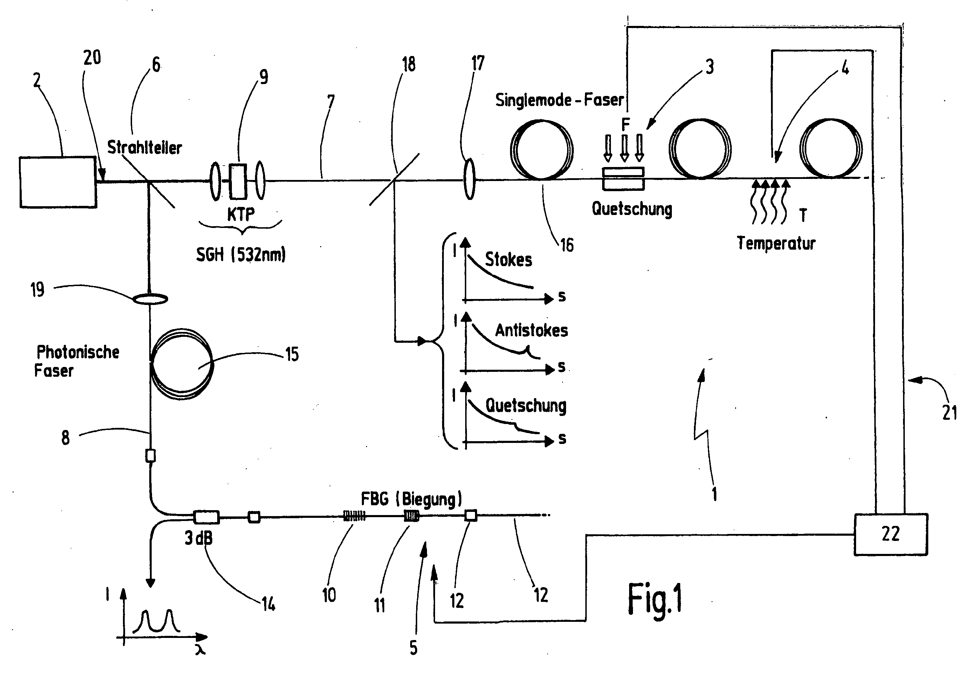

Die Figur 1 zeigt eine schematische Darstellung einer faseroptischen Messvorrichtung 1 mit einem Laser 2. Die Messvorrichtung besteht dabei aus einer Mehrzahl von Sensoren 3,4,5 zur Messung von Quetschung, Temperatur und/oder Biegung vorzugsweise eines Kabels.

Die Vorrichtung 1 weist einen Strahlteiler 6 auf, welcher den Licht- oder Laserstrahl auf zwei Fasern 7,8 aufteilt. Im Strahl der Faser 7 ist eine Vorrichtung 9 zur Frequenzverdoppelung vorgesehen, eine Linse 17, und ein weiterer Strahlteiler 18. Im Strahl der Faser 8 ist eine Linse 19 angeordnet.

Der Sensor 5 zur Messung von Dehnung und Torsion des Kabels 20, wie des Stromkabels, besteht aus mehreren aufeinander folgenden Faser-Bragg-Gittern (FBG) 10,11,12 in einer Glasfaser 13, die bei unterschiedlichen Wellenlängen das geführte Licht reflektieren. Mit Hilfe einer Breitband-Strahlquelle und einem Mikrospektrometer 14 wird die spektrale Verschiebung der reflektierten FBG-Wellenlängen  gemessen. Breitband-Strahlquellen lassen sich bei verschiedenen Wellenlängen kostengünstig fertigen. Verfügbar sind sie vorteilhaft in Form von LEDs vor allem im sichtbaren Bereich, im Bereich 800-850 nm und um 1550-1600 nm.

FBG sind kommerziell beispielsweise bei Wellenlängen um 1550 nm verfügbar. Mit leistungsstarken Femtosekunden-Laserpulsen lassen sich aber periodische Brechungsindexmodulationen in beliebige Gläser hineinschreiben, so dass mit dieser Methode insbesondere FBG bei 800-850 nm in gewöhnlichen Lichtleiterkabel hergestellt werden können. Dadurch ergibt sich eine erhebliche Kostenreduzierung für ein entsprechendes FBG Sensorsystem 21, da insbesondere für die Detektoren auf Standard Siliziumtechnologie zurückgegriffen werden kann.

Der ortsauflösende fasergestützte Temperatursensor 4 basiert auf der zeitaufgelösten Messung von Laserrückstreusignalen. Wesentlich dabei ist, dass die Anti-Stokes-Ramanlinie auf einem nichtlinearen Anregungsprozess beruht und somit von der Umgebungstemperatur abhängt. In die Faser 7 werden daher kurze und intensive Lichtpulse mit hoher Spitzenleistung eingekoppelt und das zeitliche Abklingen der Intensität der rückgestreuten Raman-Photonen gemessen.

Aufgrund des geringen Streuquerschnitts werden Einzelphotonen gezählt, die über viele Laserpulse aufsummiert werden. Da der Streuquerschnitt für kurze Laserwellenlängen stark zunimmt, wird für diesen Sensor 4 bevorzugt eine Lichtquelle, wie beispielsweise ein Mikrochiplaser im Sichtbaren bzw. im nahen Infrarotbereich bevorzugt. Für Einzelsystemlösungen bieten hier im Kurzpulsbetrieb betriebene Halbleiterlaser oder auch Leuchtdioden Möglichkeiten zu wirtschaftlich besonders interessanten Systemlösungen. Der sichtbare Spektralbereich bietet den weiteren Vorteil, dass hier Photomultiplier als extrem empfindliche Einzelphotonenzähler zur Verfügung stehen.

Als Gassensor zur Messung des Ozongehalts der Umgebungsluft oder auch anderer korrosiver Gase wird ein auf Leuchtdioden (LED) basierendes Sensorelement eingesetzt. Dieses besteht aus einem Hohlzylinder, dessen Innenfläche derart geformt ist, dass sämtliche einfallenden Strahlen in einem Punkt gesammelt werden. Mit dieser Anordnung ist es möglich, eine extrem divergente Strahlquelle, wie beispielsweise eine LED punktförmig zu fokussieren. Auf der einen Seite des Zylinders ist eine im ultravioletten Spektralbereich emittierende LED montiert, auf der anderen Seite ein geeigneter Detektor, z.B. eine Photodiode.

Über die geometrische Abbildung durch den geeignet, insbesondere hyperbelförmig geformten Hohlzylinder wird nun das LED-Licht vollständig auf den Detektor abgebildet. Der Hohlzylinder wird nun von dem zu untersuchenden Gas durchströmt und wirkt dabei als optische Absorptionszelle. Bei geeigneter Wahl der LED Wellenlänge, z.B. 250 nm für Ozonmessungen, wird ein Teil dieses Lichtes bei der Ausbreitung im Hohlzylinder absorbiert und diese Intensitätsänderung kann über das Beer-Lambertsche Absorptionsgesetz auf eine Teilchenkonzentration, wie beispielsweise das Ozon, zurückgerechnet werden. Das elektrische Photodiodensignal wird in ein optisches Signal konvertiert und mittels Lichtleiter zur Leitstelle übertragen. Damit ergibt sich die Möglichkeit, ein miniaturisiertes, netzwerkintegriertes Sensorelement für den permanenten Spurennachweis von z.B. Ozonkonzentrationen mit vergleichsweise einfachen Komponenten herzustellen.

Die Einzelsensoren sind dabei autarke Einzelkomponenten, da ultraviolette Strahlung im Wesentlichen nur in Quarzfasern übertragen werden kann, die derzeit aber nicht standardmäßig für Datenübertragung eingesetzt werden. Die faseroptische Vernetzung erfolgt daher lediglich über die optische Datenübertragung in Standardlichtleitern.

Ein Aspekt eines Ausführungsbeispiels der Erfindung ist die Vernetzung unterschiedlicher Sensoren zu einem Fasernetzwerk 21 für die Überwachung des Belastungszustandes von Kabeln, wie beispielsweise von Energiekabeln. Dieses ist insbesondere dann wirtschaftlich umsetzbar, wenn die kostenintensiven Komponenten in ihrer Anzahl reduziert werden können, was durch den oben beschriebenen Netzwerkansatz erreicht wird.

Umsetzbar ist dieser Aspekt der Erfindung vorteilhaft dann, wenn eine einzige Strahlquelle für die verschiedenen Sensoren identifiziert wird. Dieses erfolgt vorteilhaft durch den Einsatz einer Ultrakurzpulsquelle mit entsprechender spektraler Bandbreite. Die bevorzugte Ausführungsform einer derartigen Strahlquelle ist ein Mikrochiplaser mit einer nachgeschalteten photonischen Faser 15 zur Erzeugung von Weißlicht (Kontinuumstrahlung), wobei anschließend durch geeignete Wahl von Farbfiltern aus dem Weißlichtspektrum die für die Sensorik interessanten Spektralbereiche herausgefiltert werden können. Auf diese Weise kann eine einzige Strahlquelle 2 sowohl für die FBG Sensorik 5 (z.B. Spektralbereich 800-850 nm) als auch für die Temperaturmessung 4 und mechanische Belastung bei Quetschungen 3 mittels zeitaufgelöster Raman Rückstreumessungen verwendet werden.

Nach Stand der Technik benötigt jedes einzelne faseroptische Sensorprinzip jeweils spezielle Strahlquellen, so dass die Herstellung eines faseroptischen Sensornetzwerkes unter wirtschaftlichen Gesichtspunkten nicht praktikabel ist.

Passiv gütegeschaltete Mikrochiplaser sind technologisch einfache Strahlquellen, die Lichtpulse im Nanosekundenbereich mit Wiederholraten bis in den kHz-Bereich emittieren und aufgrund der hohen Pulsspitzenleistungen sich sehr gut eignen, durch Ausnutzung nichtlinearer optischer Effekte in beispielsweise photonischen Fasern Weißlicht zu erzeugen. Damit lässt sich dann ein faseroptisches Sensornetzwerk mit den oben beschriebenen Eigenschaften unter wirtschaftlichen Gesichtspunkten realisieren.

Die Figur 1 zeigt das Prinzip eines derartigen Sensor-Fasernetzwerkes 1, wie es zur Echtzeit-Überwachung thermischer und mechanischer Belastungen eingesetzt werden kann. Gezeigt ist der Mikrochiplaser 2 als Primärstrahlquelle, mit einem Strahlteiler 6 wird ein Teil der Strahlung abgezweigt, ggf. frequenzverdoppelt 9 und anschließend in eine gewöhnliche Telekommunikationsfaser 16 eingekoppelt um über Erfassung von Raman Rückstreusignalen ortsaufgelöst thermische und mechanische Störungen in dem Kabel zu erfassen.

Das Lichtleitkabel selbst ist in ein Energiekabel integriert. Der andere Teil der Laserstrahlung wird in eine photonische Faser 15 zur Kontinuumerzeugung eingekoppelt. Diese Faser ist wiederum mit einer weiteren Telekommunikationsfaser verspleisst, in die vorher an geeigneten Positionen FBG 10,11,12 mit Femtosekunden-Lichtimpulsen hineingeschrieben wurden. Die Messung der rückgestreuten Frequenzanteile erlaubt die Erfassung mechanischer Belastungen, z.B. Verdrillungen und Biegungen, des Kabels.

Als Einzelkomponente für das Sensorsystem ist die Erfassung der mechanischen Belastungszustände im Energiekabeln mit integrierten Standard-Lichtwellenleitern durch zeitaufgelöste Messung von Lichtrückstreusignalen zu nennen. Die Lichtanregung kann mit einem selektierten Frequenzbereich der oben beschriebenen Weißlichtquelle erfolgen und so in ein Sensornetzwerk 21 integriert werden.

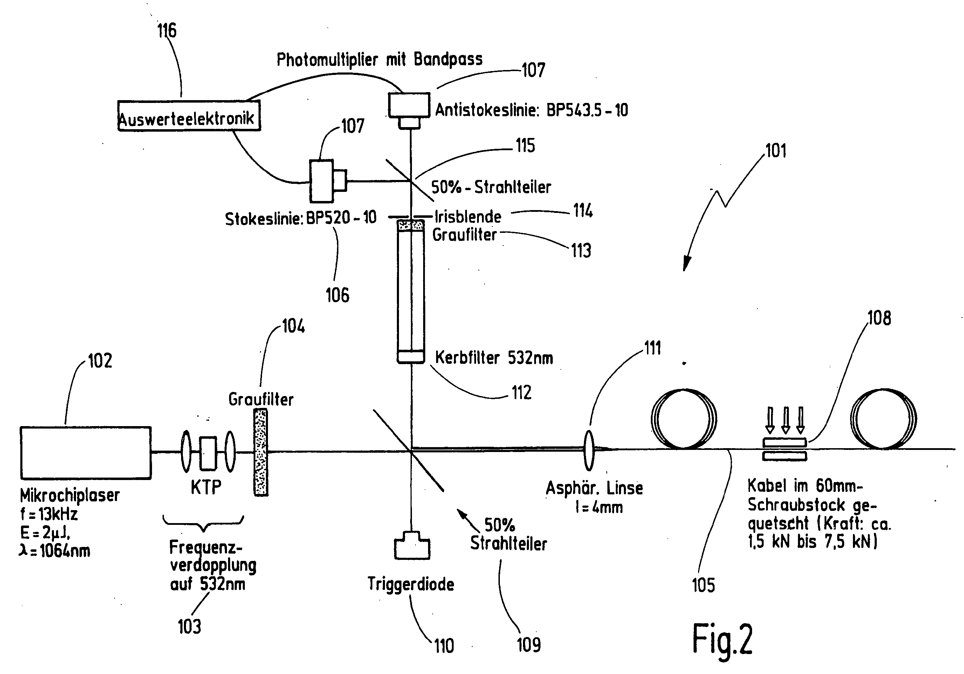

Ein Ausführungsbeispiel einer Einzellösung dieser Vorrichtung 101 ist in der Figur 2 gezeigt. Hier wird die grüne Emission eines Mikrochiplasers 102 zur optischen Anregung verwendet. Nach dem Laser 102 wird eine Frequenzverdoppelung 103 durchgeführt, dem ein Graufilter 104 nachgeschaltet ist.

Wird Licht mit hinreichender Intensität in einem Lichtwellenleiter 105 geführt, so wird eine in den roten Spektralbereich verschobene Streukomponente beobachtet (Stokes Komponente 106), sowie eine deutlich schwächere und in den blauen Spektralbereich verschobene Komponente (Anti-Stokes Komponente 107). Die Anti-Stokes Komponente 107 ist dabei quadratisch von der eingestrahlten Lichtintensität abhängig:

$$I_{AS} \sim I_L^2 \qquad\qquad\qquad (1)$$

Wird das Kabel oder Energiekabel 108 an einer Stelle besonders hohen mechanischen Belastungen ausgesetzt, z.B. durch Quetschungen, dann bilden sich an dieser Stelle in dem in das Energiekabel 108 integrierten Lichtleiter 105 verstärkt Streuzentren aus, die durch zeitaufgelöste Messung von Stokes und Anti-Stokes Rückstreusignalen identifiziert werden können. Weiterhin erkennbar ist eine Strahlteiler 109 und eine diesbezügliche Triggerdiode 110, eine asphärische Linse 111. In dem Strahlengang nach dem Strahlteiler 109 ist ein Kerbfilter 112, ein Graufilter 113 und eine Irisblende 114 mit einem nachfolgenden Strahlteiler 115 sowie eine Auswerteelektronik nach den Photomultipliern 107.

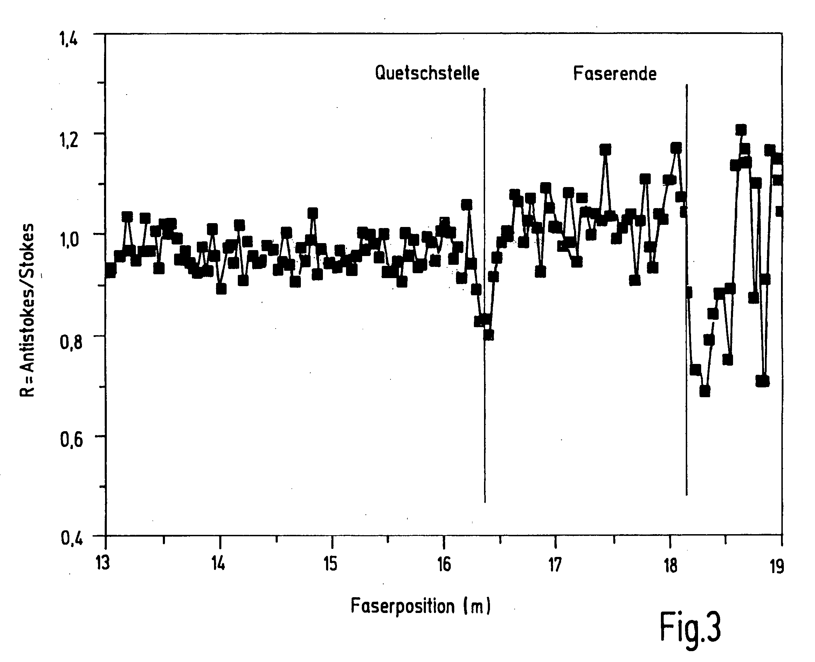

Die Figur 3 zeigt das Verhältnis von Anti-Stokes zu Stokes Signal für unterschiedliche Faserpositionen, wobei die Faserposition 16.5 m einer mechanischen Quetschbelastung ausgesetzt wurde. Der Quetschbereich kann eindeutig lokal identifiziert werden.

Insbesondere die Messung der Anti-Stokes Raman Linienintensität bietet dabei aufgrund der quadratischen Intensitätsabhängigkeit die Möglichkeit der sehr empfindlichen Messwerterfassung. Die Stokes Linienintensität kann dann beispielsweise der Signalnormierung dienen. Besonders vorteilhaft ist die Verwendung gepulster Halbleiterlaser oder auch LEDs anstelle des Mikrochiplasers beispielsweise bei der Netzwerkvariante, da dies kostengünstig sein kann.

Im Fall von Sensornetzwerken wird erfindungsgemäß ein lichtintensiver Mikrochiplaser ggf. mit nachgeführter Weißlicht- oder Kontinuumerzeugung als zentrale Lichtquelle verwendet, der dann über Multiplexing zu den einzelnen Messstellen geführt wird. Das Rückstreulicht (Stokes und Anti-Stokes) kann dann über sequentielles Abfragen der verschiedenen Lichtleiter wieder von einer zentralen Datenerfassungs- und -auswerteeinheit 22 verarbeitet werden. Durch diese Art der Vernetzung lassen sich die Kosten für eine einzelne Messfaser deutlich reduzieren.

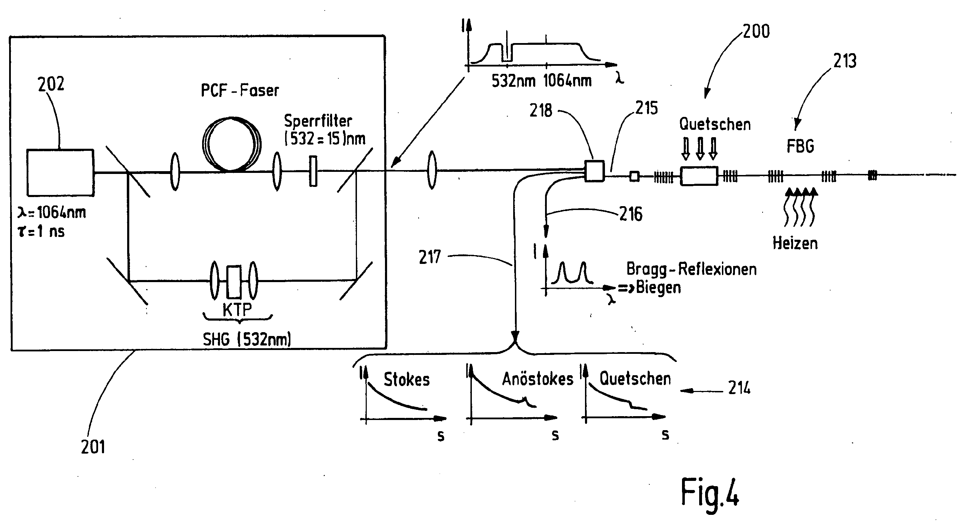

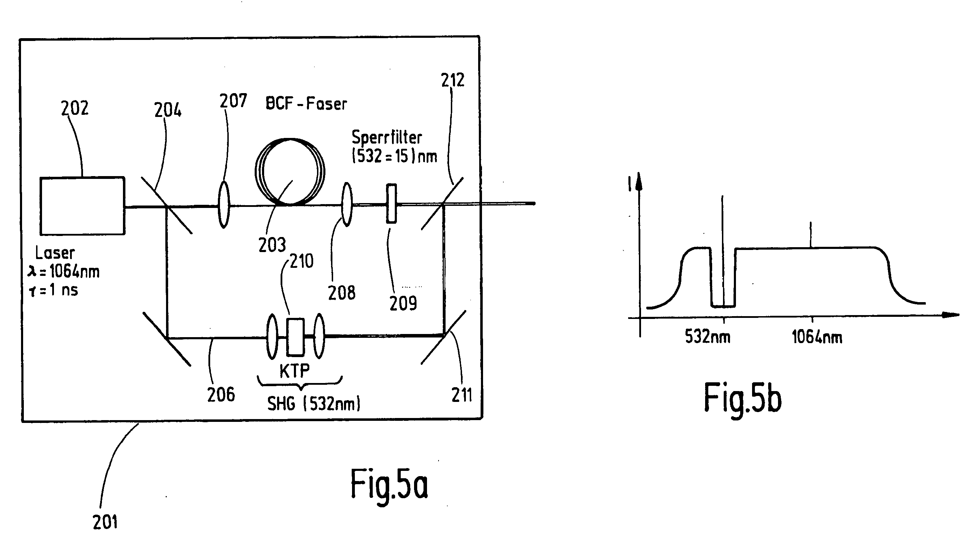

Eine weitere besonders vorteilhaften Ausführungsform der erfindungsgemäßen Messvorrichtung 200 ist in der Fig. 4 dargestellt. Die Lichtquelle 201 ist detaillierter in der Figur 5a dargestellt. Die Fig. 4 zeigt ein faseroptisches Sensorsystem mit einer kombinierten Kontinuum/Kurzpulsstrahlquelle und mit nur einem Lichtwellenleiter (LWL) zur simultanen, ortsaufgelösten Raman-Rückstreumessung und FBG-Messung insbesondere zur Erfassung mechanischer Belastungen eines Energiekabels, wenn in dieses der Lichtwellenleiter integriert ist.

Die Fig. 5a zeigt eine kombinierte Breitband- und Kurzpulsquelle für ein faseroptisches Messsystem. Dabei zeigt die Figur 5a den Aufbau und die Komponenten der Strahlquelle. Die Figur 5b zeigt die spektrale Intensitätsverteilung der Strahlquelle als Funktion der Wellenlänge.

Die Lichtquelle 201 besteht vorteilhaft aus einem Mikrochiplaser 202 mit nachgeführter bzw. nachfolgender Photonischer Faser (PCF Faser) 203 zur Erzeugung von Kontinuumsstrahlung, insbesondere mit spektraler Aufweitung. Nach dem Mikrochiplaser 202 ist ein Strahlteiler 204 angeordnet, welcher den Strahl aufteilt in den Strahl 205 und den Strahl 206. Die Lichtquelle 201 ist vorteilhaft eine Quelle für ein gepulstes Kontinuum eine Einzelfrequenz-Laserstrahlung. Weiterhin sind in dem Strahl 205 Linsen 207,208 angeordnet. Mit einem so genannten Notch-Filter 209 (z.B 532 nm +- 15 nm) wird der Spektralbereich der zweiten Harmonischen des verwendeten Lasers, wie Mikrochiplasers, (532 nm) in dem Intervall +- 15 nm für die Kontinuumsemission geblockt, siehe das Diagramm der Figur 5b, in welchem die Intensität der Strahlung als Funktion der Wellenlänge aufgetragen ist.

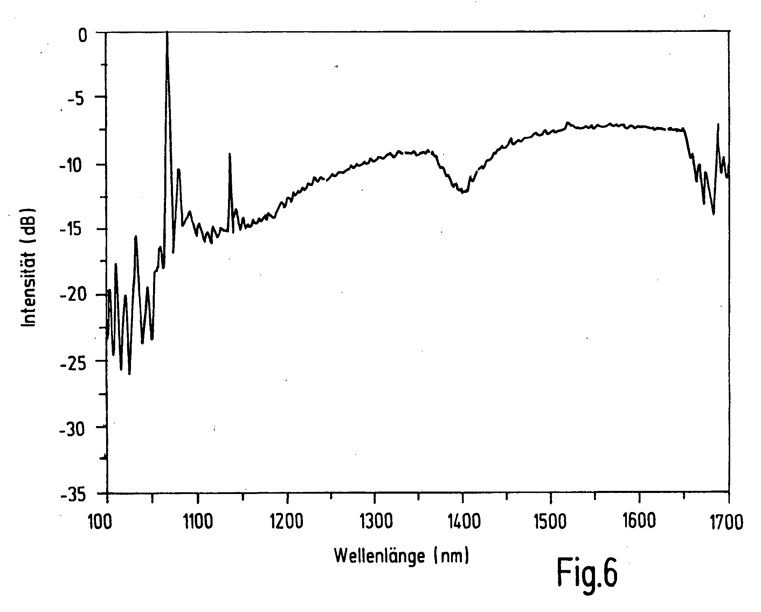

Ein Ausschnitt der mit dieser Anordnung im infraroten Spektralbereich erzeugten Kontinuumsstrahlung für Wellenlängen oberhalb von 1064 nm ist in der Fig. 6 gezeigt. Die Fig. 6 zeigt insbesondere die Erzeugung von Weißlicht in Kontinuumemission oberhalb von einer Wellenlänge von 1064 nm bei Verwendung eines Lasers, wie Mikrochiplasers bei 1064 nm Wellenlänge und bei Anwendung einer Photonischen Faser.

Ein Teil der Fundamentalen der Mikrochiplaseremission (1064 nm) wird in einem abgezweigten Stahlausschnitt 206 mit einem nichtlinearen Kristall 210 (z.B. KDP Kristall) frequenzverdoppelt auf die Wellenlänge von 532 nm und anschließend mit dem Ausgang der PCF Faser wieder überlagert. Dazu sind die beiden Vorrichtungen 211,212 vorgesehen. Damit ergibt sich eine Emission in der Art wie sie in Fig. 5b am Ausgang der Strahlquelle gezeigt ist: Es ergibt sich eine Breitbandemission mit einer Lücke bei 532 nm, die mit einem intensiven Laserlinie bei 532 nm überlagert ist.

Die Vorteile dieser Anordnung sind dabei, dass nur eine einzige Strahlquelle 201 bereitgestellt wird, die sich sowohl zur Anregung von FBG Sensoren 213 bei Kontinuumstrahlung als auch zu Raman-Messungen 214 bei der 532 nm Laserlinie in einer einzigen Faser eignet.

In die Lichtleitfaser werden vorzugsweise mittels Femtosekunden-Laserbeleuchtung Faser Bragg Gitter (FBG) Strukturen 213 mit definierten Gitterwellenlängen hineingeschrieben, die dann als FBG Sensoren dienen. Solange die Gitterwellenlänge der FBG 213 nicht mit der Wellenlänge 532 nm korrespondiert, wird der 532 nm Lichtpuls von den FBGs 213 nicht beeinflusst.

Auf diese Weise kann in derselben Faser 215, welche auch die FBGs 213 enthält, eine Raman-Rückstreumessung 214 durchgeführt werden zur Bestimmung räumlich aufgelöster Temperaturen bzw. Quetschungen.

Die rückgeführten Signale 216 reflektierte Wellenlängen der FBG-Sensoren 213 und die Raman-Signale 217 werden mittels eines Faserkopplers 218 voneinander getrennt und unabhängig ausgewertet.

Dieses Prinzip ermöglicht so erfindungsgemäß die simultane Erfassung von Temperaturen, Quetschungen und/oder mechanischen Belastungen, wie beispielsweise Biegungen und Drillungen beispielsweise eines Energiekabels, welches bevorzugt mit einem einzigem Lichtleitkabel versehen ist und in welches mit der Femtosekunden Lasermethode FBGs hineingeschrieben wurden.

Die oben beschriebene Methode ist nicht auf die Wellenlänge von 532 nm beschränkt, sondern kann auch für andere beliebige Lichtwellenlängen eingesetzt werden, sofern in dem ausgesuchten Spektralbereich eine intensive Laserpulswellenlänge verfügbar ist.

Vorteilhaft ist es bei diesem Messprinzip, wenn die Verwendung eines sogenannten Notch-Filter, wie Kerbfilter oder Sperrfilter, für die ausgewählte Laserwellenlänge von beispielsweise 532 nm mit einer Unterdrückung von $> 10^3$ in einem Wellenlängenbereich von z.B. +- 15 nm um die ausgewählte Laserwellenlänge im Strahlengang der Kontinuumsemission. Dieses ermöglicht eine empfindliche Messung der Stokes- und Antistokes-Emission bei der Temperaturbestimmung, da dann vorteilhaft kaum oder keine Überlagerung mit entsprechenden Wellenlängen des Kontinuumemitters auftritt.

Bezugszeichenliste

1     Messvorrichtung

2     Laser

3     Sensor

4     Sensor

5     Sensor

6     Strahlteiler

7     Faser

8     Faser

9     Vorrichtung

10     Faser-Bragg-Gitter

11     Faser-Bragg-Gitter

12     Faser-Bragg-Gitter

13     Glasfaser

14     Mikrospektrometer

15     photonische Faser

16     Telekommunikationsfaser

17     Linse

| 18 | Strahlteiler |
|---|---|
| 19 | Linse |
| 20 | Kabel |
| 21 | Sensorsystem/Fasernetzwerk/Sensornetzwerk |
| 22 | Datenerfassungs- und Auswerteeinheit/Zentrale Auswerteeinheit |
| 101 | Vorrichtung |
| 102 | Laser |
| 103 | Frequenzverdoppelung |
| 104 | Graufilter |
| 105 | Lichtwellenleiter |
| 106 | Stokes Komponente |
| 107 | Anti-Stokes-Komponente / Photomultiplier |
| 108 | Energiekabel |
| 109 | Strahlteiler |
| 110 | Triggerdiode |
| 111 | asphärische Linse |
| 112 | Kerbfilter |
| 113 | Graufilter |
| 114 | Irisblende |
| 115 | Strahlteiler |
| 200 | Messvorrichtung |
| 201 | Lichtquelle |
| 202 | Mikrochiplaser |
| 203 | photonische Faser |
| 204 | Strahlteiler |
| 205 | Strahl |
| 206 | Stahlausschnitt |
| 207 | Linse |
| 208 | Linse |

| 209 | Notch-Filter |
| 210 | Kristall |
| 211 | Vorrichtung |
| 212 | Vorrichtung |
| 213 | Faser-Bragg-Gitter |
| 214 | Raman-Rückstreuung |
| 215 | Faser |
| 216 | Signal |
| 217 | Raman-Signal |
| 218 | Faserkoppler |

**Patentansprüche**

1. Faseroptische Messvorrichtung (1) mit einer Anzahl von Sensoren (3, 4, 5), welche in ein elektrisches Energiekabel (20) integriert sind, um eine mechanische Belastung, eine Temperatur und/oder korrosive Gase zu erfassen, die auf das elektrische Energiekabel einwirken, wobei ausgehend von einer Strahlquelle (2, 102, 202) zumindest eine Lichtleitfaser (7, 8) vorhanden ist, an oder in welche die Sensoren (3, 4, 5) vorhanden sind und die Sensoren (3, 4, 5) mit Licht der Strahlquelle (2, 102, 202) gespeist sind, wobei ein erster Sensor (3) zur Erkennung der mechanischen Verformung und ein zweiter Sensor (4) zur Erkennung der Temperatur an einer Lichtleitfaser (7) vorhanden sind, sowie ein dritter Sensor (5) zur Erkennung einer Biegung vorhanden ist, **dadurch gekennzeichnet, dass** ausgehend von der Strahlquelle (2, 102, 202) ein Strahlteiler (6) vorhanden ist und zumindest zwei Lichtleitfasern (7, 8) vorhanden sind, an oder in welchen die Sensoren (3, 4, 5) vorhanden sind, so dass die Sensoren (3, 4, 5) ein faseroptisches Sensornetzwerk bilden.

2. Faseroptische Messvorrichtung nach Anspruch 1, **dadurch gekennzeichnet, dass** die Sensoren (3, 4, 5) miteinander gekoppelt sind, derart, dass die Signale der Sensoren (3, 4, 5) mittels einer zentralen Auswerteeinheit (22) ausgewertet werden und/oder die Sensorelemente (3, 4, 5) mit nur einer einzigen Strahlquelle (2, 102, 202) betrieben werden.

3. Faseroptische Messvorrichtung nach einem der vorhergehenden Ansprüche, **dadurch gekennzeichnet, dass** der dritte Sensor (5) zur Erkennung der Biegung an der gleichen Lichtleitfaser (7) vorhanden ist, an der auch der erste (3) und der zweite Sensor (4) vorhanden ist, oder an der wenigstens eine andere Lichtleitfaser (7, 8) vorhanden ist.

4. Faseroptische Messvorrichtung nach einem der vorhergehenden Ansprüche, **dadurch gekennzeichnet, dass**, die Messvorrichtung so gestaltet ist, dass ein Einbringen von periodischen Brechungsindexstrukturen in die Lichtleitfaser (7, 8) durch lokale Fokussierung ultrakurzer Lichtimpulse in den Kern der Lichtleitfaser (7, 8) vorhanden ist, so dass je nach Periodenabstand einzelne Frequenzen einer Weißlichtquelle oder eines Breitbandemitters reflektiert werden.

5. Faseroptische Messvorrichtung nach einem der vorhergehenden Ansprüche, **dadurch gekennzeichnet, dass** die Messvorrichtung so gestaltet ist, dass aus einer Verschiebung von rückreflektierten Frequenzanteilen auf die mechanische Belastung der Lichtleitfaser (7, 8), beispielsweise durch Biegung oder Verdrillung schließbar ist und damit auf die mechanische Belastung des elektrischen Energiekabels schließbar ist, in das die Lichtleitfaser (7, 8) integriert ist.

6. Faseroptische Messvorrichtung nach einem der vorhergehenden Ansprüche, **dadurch gekennzeichnet, dass** eine zeitaufgelöste Messung von Lichtrückstreusignalen ermöglicht ist, nachdem ein intensiver Kurzpulslaserstrahl in eine unbehandelte Lichtleitfaser (7, 8) eingekoppelt wurde.

7. Faseroptische Messvorrichtung nach einem der vorhergehenden Ansprüche, **dadurch gekennzeichnet, dass** eine zeitaufgelöste Lichtrückstreumessung für zwei unterschiedlich gestreute Lichtkomponenten eine lokale Temperaturmessung und/oder eine lokale Erfassung mechanischer Belastungen der Faser (7, 8) und damit des elektrischen Energiekabels ermöglicht.

8. Faseroptische Messvorrichtung nach einem der vorhergehenden Ansprüche, **dadurch gekennzeichnet, dass** die Strahlquelle (2, 102, 202) ein passiv gütegeschalteter Mikrochiplaser mit nachfolgender Weißlichterzeugung ist.

9. Faseroptische Messvorrichtung nach dem vorhergehenden Anspruch, **dadurch gekennzeichnet, dass** die Weißlichterzeugung durch ein nachgeschaltetes nichtlineares optisches Bauelement, vorzugsweise eine photonische Faser, erfolgt.

10. Faseroptische Messvorrichtung nach Anspruch 8 oder 9, wobei aus dem Weißlichtspektrum mittels optischer Filter Frequenzbereiche herausfilterbar sind, mit welchen die einzelnen Sensorelemente ansteuerbar sind.

11. Faseroptische Messvorrichtung nach einem der vorhergehenden Ansprüche 9 oder 10, **dadurch gekennzeichnet, dass** die Vernetzung der einzelnen Sensoren (3, 4, 5) durch Multiplexing erfolgt und die Abfrage der Messsignale sequentiell erfolgt.

12. Faseroptische Messvorrichtung nach einem der vohergehenden Ansprüche mit einer Strahlquelle (2, 102, 202), **dadurch gekennzeichnet, dass** die Strahlquelle (2, 102, 202) ein Laser ist, zur Erzeugung von Kontinuumsstrahlung und Kurzpulsemission bei einer definierten Laserwellenlänge, wobei ein Filter, wie z. B. ein Interferenzfilter, die Kontinuumsemmission außerhalb einem definierten Spektralbereiches um die definierte Laserwellenlänge herum unterdrückt.

13. Strahlquelle nach Anspruch 12, wobei der Interferenzfilter ein Notch-Filter (209) oder ein Sperrfilter oder ein Kerbfilter ist.

14. Strahlquelle nach Anspruch 13, wobei die Strahlquelle (2, 102, 202) zur Einkopplung der erzeugten elektromagnetischen Strahlung in die Lichtleitfaser (7, 8) zur simultanen Messung von ortsaufgelösten Temperaturen und mechanischen Belastungen dient, wobei die Lichtleitfaser (7, 8) Teil einer Messvorrichtung ist, welche mit Lichtleitfaser Bragg Gittern (10, 11, 12, 213) versehen ist.

15. Faseroptische Messvorrichtung nach einem der vorhergehenden Ansprüche, in welche eine von der Strahlquelle (2, 102, 202) erzeugte elektromagnetische Strahlung in die Lichtleitfaser (7, 8) einkoppelbar ist, insbesondere zur simultanen Messung von ortsaufgelösten Temperaturen und mechanischen Belastungen, wobei die Lichtleitfaser (7, 8) mit Lichtleitfaser Bragg Gittern (10, 11, 12, 213) versehen ist.

16. Faseroptische Messvorrichtung nach Anspruch 15, wobei die Periode der Lichtleitfaser Bragg Gitter (10, 11, 12, 213) so gewählt ist, dass kein Lichtleitfaser Bragg Gitter (10, 11, 12, 213) mit der ausgewählten Laserwellenlänge korrespondiert, so dass sich die Strahlung mit der ausgewählten Laserwellenlänge ungestört in der Lichtleitfaser (7, 8) ausbreiten kann und vorteilhaft zur ortsaufgelösten Temperatur- bzw. Quetschmessung verwendet werden kann.

17. Faseroptische Messvorrichtung nach Anspruch 15 oder 16, wobei die Lichtleitfaser Bragg Gitter (10, 11, 12, 213) mit ultrakurzen Lichtpulsen, wie beispielsweise Femtosekunden- Lichtpulsen, in die Lichtleitfaser (7, 8) hineingeschrieben werden.

18. Faseroptische Messvorrichtung nach Anspruch 15, 16 oder 17, wobei mittels eines Faserkopplers (218) die rücklaufenden Signalanteile der Sensoren (3, 4, 5) voneinander getrennt werden.

19. Verfahren zum Betreiben einer faseroptischen Messvorrichtung nach einem der vorhergehenden Ansprüche.

**Claims**

1.  Fibre-optic measuring apparatus (1) with a plurality of sensors (3, 4, 5), which are integrated into an electrical power cable (20) in order to detect a mechanical stress, a temperature and/or corrosive gases which act on the electrical power cable,
    wherein starting from a beam source (2, 102, 202), at least one optical fibre (7, 8) is present, on or in which the sensors (3, 4, 5) are present and the sensors (3, 4, 5) are supplied with light from the beam source (2, 102, 202), wherein a first sensor (3) for detecting the mechanical deformation and a second sensor (4) for detecting the temperature on an optical fibre (7) are present, and a third sensor (5) is present for detecting a flexing,
    **characterized in that**
    starting from the beam source (2, 102, 202), a beam splitter (6) is present and at least two optical fibres (7, 8) are present, on or in which the sensors (3, 4, 5) are present, so that the sensors (3, 4, 5) form a fibre-optic sensor network.

2.  Fibre-optic measuring apparatus according to Claim 1,
    **characterized in that**
    the sensors (3, 4, 5) are coupled to each other, in such a manner that the signals from the sensors (3, 4, 5) are evaluated by means of a central evaluation unit (22) and/or the sensor elements (3, 4, 5) are operated with only a single beam source (2, 102, 202).

3.  Fibre-optic measuring apparatus according to any one of the preceding claims,
    **characterized in that**
    the third sensor (5) for detecting the flexing is present on the same optical fibre (7) on which the first (3) and the second sensor (4) are also present, or on which at least one other optical fibre (7, 8) is present.

4.  Fibre-optic measuring apparatus according to any one of the preceding claims,
    **characterized in that**
    the measuring device is designed such that periodic refractive index structures are incorporated into the optical fibre (7, 8) by local focussing of ultra-short light pulses into the core of the optical fibre (7, 8), so that depending on the period interval, individual frequencies of a white-light source or of a broadband emitter are reflected.

5.  Fibre-optic measuring apparatus according to any one of the preceding claims,
    **characterized in that**
    the measuring device is designed such that the mechanical stress on the optical fibre (7, 8), for example, due to bending or twisting, can be inferred from a shift of back-reflected frequency components, and therefore the mechanical stress on the electrical power cable into which the optical fibre (7, 8) is integrated can also be inferred.

6.  Fibre-optic measuring apparatus according to any one of the preceding claims,
    **characterized in that**
    a time-resolved measurement of backscattered light signals is enabled once an intensive short-pulsed laser beam has been coupled into an untreated optical fibre (7, 8).

7.  Fibre-optic measuring apparatus according to any one of the preceding claims,
    **characterized in that**
    a time-resolved backscattered light measurement for two differently scattered light components enables a local temperature measurement and/or a local detection of mechanical stresses on the fibre (7, 8) and therefore on the electrical power cable.

8.  Fibre-optic measuring apparatus according to any one of the preceding claims,
    **characterized in that**
    the beam source (2, 102, 202) is a passive Q-switched microchip laser with subsequent white light generation.

9.  Fibre-optic measuring apparatus according to the preceding claim,
    **characterized in that**
    the white light is generated by a downstream non-linear optical component, preferably a photonic fibre.

10. Fibre-optic measuring apparatus according to Claim 8 or 9, wherein by means of optical filters, frequency ranges can be filtered out of the white light spectrum, with which the individual sensor elements can be accessed.

**11.** Fibre-optic measuring apparatus according to one of the preceding Claims 9 or 10,
**characterized in that**
the individual sensors (3, 4, 5) are networked together by multiplexing and the querying of the measurement signals takes place sequentially.

**12.** Fibre-optic measuring apparatus according to any one of the previous claims with a beam source (2, 102, 202),
**characterized in that**
the beam source (2, 102, 202) is a laser, for generating continuum radiation and short-pulse emission at a defined laser wavelength, wherein a filter, such as e.g. an interference filter, suppresses the continuum emission outsided a defined spectral range around the defined laser wavelength.

**13.** Beam source according to Claim 12, wherein the interference filter is a notch filter (209) or a blocking filter or a band-stop filter.

**14.** Beam source according to Claim 13, wherein the beam source (2, 102, 202) is used for coupling the generated electromagnetic radiation into the optical fibre (7, 8) for the simultaneous measurement of spatially resolved temperatures and mechanical stresses, wherein the optical fibre (7, 8) is part of a measuring apparatus, which is provided with optical-fibre Bragg gratings (10, 11, 12, 213).

**15.** Fibre-optic measuring apparatus according to any one of the preceding claims, in which an electromagnetic radiation generated by the beam source (2, 102, 202) can be coupled into the optical fibre (7, 8), in particular for the simultaneous measurement of spatially resolved temperatures and mechanical stresses, wherein the optical fibre (7, 8) is provided with optical-fibre Bragg gratings (10, 11, 12, 213).

**16.** Fibre-optic measuring apparatus according to Claim 15, wherein the period of the optical-fibre Bragg gratings (10, 11, 12, 213) is selected such that no optical-fibre Bragg grating (10, 11, 12, 213) corresponds to the selected laser wavelength, so that the radiation with the selected laser wavelength can propagate freely in the optical fibre (7, 8) and can be used advantageously for the purpose of spatially resolved measurement of temperature or squeezing.

**17.** Fibre-optic measuring apparatus according to Claim 15 or 16, wherein the optical fibre Bragg gratings (10, 11, 12, 213) can be inscribed into the optical fibre (7, 8) with ultra-short light pulses, for example femtosecond light pulses.

**18.** Fibre-optic measuring apparatus according to Claim 15, 16 or 17, wherein the returning signal components of the sensors (3, 4, 5) can be separated from each other by means of a fibre coupler (218).

**19.** Method for operating a fibre-optic measuring apparatus according to any one of the previous claims.

**Revendications**

**1.** Dispositif de mesure à fibre optique (1) avec un certain nombre de capteurs (3, 4, 5), lesquels sont intégrés dans un câble d'énergie électrique (20) afin de détecter une contrainte mécanique, une température et/ou des gaz corrosifs qui agissent sur la câble d'énergie électrique,
moyennant quoi, en partant d'une source de rayonnement (2, 102, 202), il y a au moins une fibre optique (7, 8) sur laquelle ou dans laquelle les capteurs (3, 4, 5) sont présents, et les capteurs (3, 4, 5) étant alimentés avec de la lumière de la source de rayonnement (2, 102, 202), moyennant quoi il y a un premier capteur (3) pour la reconnaissance de la déformation mécanique et un deuxième capteur (4) pour la reconnaissance de la température au niveau d'une fibre optique (7), ainsi qu'un troisième capteur (5) présent pour la reconnaissance d'une flexion,
**caractérisé en ce que**,
en partant de la source de rayonnement (2, 102, 202), il y a un séparateur de faisceau (6) et au moins deux fibres optiques (7, 8) sur lesquelles ou dans lesquelles les capteurs (3, 4, 5) sont présents, de sorte que les capteurs (3, 4, 5) forment un réseau de capteurs à fibre optique.

**2.** Dispositif de mesure à fibre optique selon la revendication 1,
**caractérisé en ce que**
les capteurs (3, 4, 5) sont couplés ensemble de manière à ce que les signaux des capteurs (3, 4, 5) soient évalués à l'aide d'une unité d'évaluation centrale (22) et/ou à ce que les éléments de capteur (3, 4, 5) soient exploités avec une seule source de rayonnement (2, 102, 202).

**3.** Dispositif de mesure à fibre optique selon l'une des revendications précédentes,
**caractérisé en ce que**
le troisième capteur (5) pour la reconnaissance de la flexion est présent sur la même fibre optique (7) sur laquelle il y a également les premier (3) et deuxième capteurs (4), ou sur laquelle il y a au moins une autre fibre optique (7, 8).

**4.** Dispositif de mesure à fibre optique selon l'une des revendications précédentes,
**caractérisé en ce que**
le dispositif de mesure est réalisé de manière à ce qu'il y a une introduction de structures d'indices de réfraction périodiques dans la fibre optique (7, 8) grâce à une focalisation locale d'impulsions lumineuses ultra-courtes dans le noyau de la fibre optique (7, 8), de sorte qu'en fonction de l'intervalle de période, des fréquences individuelles d'une source de lumière blanche ou d'un émetteur large bande sont réfléchies.

**5.** Dispositif de mesure à fibre optique selon l'une des revendications précédentes,
**caractérisé en ce que**
le dispositif de mesure est conçu de manière à ce qu'il soit possible, d'après un décalage de parts de fréquence réfléchies en retour, de parvenir à la conclusion d'une contrainte mécanique de la fibre optique (7, 8), par exemple du fait d'une flexion ou torsion, et par conséquent d'une contrainte mécanique du câble d'énergie électrique dans lequel la fibre optique (7, 8) est intégrée.

**6.** Dispositif de mesure à fibre optique selon l'une des revendications précédentes,
**caractérisé en ce**
**qu'**une mesure à résolution temporelle de signaux de rétrodiffusion lumineuse est rendue possible après qu'un intense rayon laser à impulsion courte a été envoyé dans une fibre optique (7, 8) non traitée.

**7.** Dispositif de mesure à fibre optique selon l'une des revendications précédentes,
**caractérisé en ce**
**qu'**une mesure de rétrodiffusion de lumière à résolution temporelle pour deux composantes lumineuses diffusées de manières différentes permet une mesure de température locale et/ou une détection locale de contraintes mécaniques de la fibre (7, 8), et par conséquent du câble d'énergie électrique.

**8.** Dispositif de mesure à fibre optique selon l'une des revendications précédentes,
**caractérisé en ce que**
la source de rayonnement (2, 102, 202) est un laser micro-puce déclenché passivement avec génération de lumière blanche qui s'en suit.

**9.** Dispositif de mesure à fibre optique selon la revendication précédente,
**caractérisé en ce que**
la génération de lumière blanche s'effectue grâce à un composant optique non linéaire monté en aval, de préférence une fibre photonique.

**10.** Dispositif de mesure à fibre optique selon les revendications 8 ou 9, dans lequel il est possible de filtrer des plages de fréquence à partir du spectre de lumière blanche à l'aide de filtres optiques, grâce auxquelles il est possible de commander les éléments de capteur individuels.

**11.** Dispositif de mesure à fibre optique selon l'une des revendications 9 ou 10 précédentes,
**caractérisé en ce que**
la mise en réseau des capteurs individuels (3, 4, 5) s'effectue par multiplexage et **en ce que** l'interrogation des signaux de mesure s'effectue de manière séquentielle.

**12.** Dispositif de mesure à fibre optique selon l'une des revendications précédentes avec une source de rayonnement (2, 102, 202),
**caractérisé en ce que**
la source de rayonnement (2, 102, 202) est un laser pour la génération d'un rayonnement à spectre continu et l'émission d'impulsions courtes en cas d'une longueur d'onde laser définie, un filtre, tel par exemple un filtre d'interférences, éliminant l'émission à spectre continu en-dehors d'une plage spectrale définie autour de la longueur d'onde laser définie.

**13.** Source de rayonnement selon la revendication 12, le filtre d'interférences étant un filtre coupe-bande (209) ou un

**14.** Source de rayonnement selon la revendication 13, dans lequel la source de rayonnement (2, 102, 202) sert à envoyer le rayonnement électromagnétique généré dans la fibre optique (7, 8) pour la mesure simultanée de températures à résolution locale et de contraintes mécaniques, la fibre optique (7, 8) étant une partie d'un dispositif de mesure, lequel est muni de réseaux de Bragg à fibre optique (10, 11, 12, 213).

**15.** Dispositif de mesure à fibre optique selon l'une des revendications précédentes, dans lequel un rayonnement électromagnétique généré par la source de rayonnement (2, 102, 202) peut être envoyé dans la fibre optique (7, 8), en particulier pour la mesure simultanée de températures à résolution locale et de contraintes mécaniques, la fibre optique (7, 8) étant munie de réseaux de Bragg à fibre optique (10, 11, 12, 213).

**16.** Dispositif de mesure à fibre optique selon la revendication 15, dans  lequel la période des réseaux de Bragg à fibre optique (10, 11, 12, 213) est choisie de manière à ce qu'aucun réseau de Bragg à fibre optique (10, 11, 12, 213) ne corresponde à la longueur d'onde laser choisie, de sorte que le rayonnement avec la longueur d'onde laser choisie peut se propager sans perturbations dans la fibre optique (7, 8) et peut être avantageusement utilisé pour la mesure de température à résolution locale ou la mesure d'écrasement.

**17.** Dispositif de mesure à fibre optique selon les revendications 15 ou 16, dans lequel les réseaux de Bragg à fibre optique (10, 11, 12, 213) sont enregistrés dans la fibre optique (7, 8) avec des impulsions lumineuses ultra-courtes, telles par exemple des impulsions lumineuses femto-secondes.

**18.** Dispositif de mesure à fibre optique selon les revendications 15, 16 ou 17, dans lequel les parts de signal de retour des capteurs (3, 4, 5) sont séparées les unes des autres par un coupleur de fibres (218).

**19.** Procédé pour faire fonctionner un dispositif de mesure à fibre optique selon l'une des revendications précédentes.

**EP 2 391 870 B1**

14

Fig.1

Fig.2

Mikrochiplaser
f = 13kHz
E = 2μJ,
λ = 1064nm

KTP

Frequenzverdopplung
auf 532nm
103

Graufilter
104

Triggerdiode
110

50%
Strahlteiler
109

Asphär. Linse
l = 4mm
111

Kabel im 60mm-
Schraubstock gequetscht (Kraft: ca.
1,5 kN bis 7,5 kN)
105
108

102

Kerbfilter 532nm
112

Graufilter
113

Irisblende
114

50% - Strahlteiler
115

Stokeslinie: BP520 - 10
106

Antistokeslinie: BP543.5 - 10
107

Photomultiplier mit Bandpass
107

Auswerteelektronik
116

101

Fig.3

Fig.4

Fig.5a

Fig.5b

EP 2 391 870 B1

Fig.6

**IN DER BESCHREIBUNG AUFGEFÜHRTE DOKUMENTE**

**In der Beschreibung aufgeführte Patentdokumente**

- WO 9932862 A1